# FASCICULE DE BREVET EUROPEEN

(11) **EP 4 565 037 B1**
(45) Date de publication et mention de la délivrance du brevet: **04.03.2026**
(21) Numéro de dépôt: 24210920.5
(22) Date de dépôt: 05.11.2024
(51) Int. Cl.: H10F 71/00, B32B 43/00

(54) **PROCÉDÉ DE DÉSASSEMBLAGE DE LA COUCHE ARRIÈRE D'UN MODULE PHOTOVOLTAÏQUE**
VERFAHREN ZUR DEMONTAGE DER RÜCKSEITENSCHICHT EINES PHOTOVOLTAIKMODULS
METHOD FOR DISASSEMBLING BACK LAYER OF PHOTOVOLTAIC MODULE

(30) Priorité: 29.11.2023 FR 2313267
(43) Date de publication de la demande: 04.06.2025
(73) Titulaire: Commissariat à l'Energie Atomique et aux Energies Alternatives, 75015 Paris (FR)
(72) Inventeur: COUSTIER, Fabrice, 38054 GRENOBLE CEDEX 09 (FR); DERRIER, Aude, 38054 GRENOBLE CEDEX 09 (FR); LANDA PLIQUET, Margot, 38054 GRENOBLE CEDEX 09 (FR); LARAIZE, Anthony, 38054 GRENOBLE CEDEX 09 (FR); RIVA, Roland, 38054 GRENOBLE CEDEX 09 (FR)
(74) Mandataire: INNOV-GROUP

(56) Documents cités:
- WO-A1-2018/096716
- FR-A1- 3 017 551
- FR-A1- 3 070 541

## Description

### Domaine technique de l'invention

La présente invention se rapporte à un procédé de désassemblage de la couche arrière d'un module photovoltaïque. L'invention concerne également le système permettant la mise en œuvre de ce procédé.

### Etat de la technique

Un module photovoltaïque comporte des cellules photovoltaïques destinées à convertir une énergie solaire en une énergie électrique.

Un tel module photovoltaïque comporte de nombreux matériaux intéressants à récupérer et à valoriser, lorsque le module est en fin de vie ou défaillant.

Classiquement, un module photovoltaïque se présente sous la forme d'un panneau composé par l'assemblage de trois couches superposées et fixées entre elles :
- Une couche arrière (appelée "backsheet") formant un premier élément de protection en face arrière ;
- Une deuxième couche, dite couche intermédiaire ; cette couche intermédiaire comporte les cellules photovoltaïques, la connectique électrique entre les cellules et une enveloppe d'encapsulation arrangée autour des cellules photovoltaïques ; cette enveloppe d'encapsulation peut être formée de deux films de protection, entre lesquels sont placées les cellules photovoltaïques ;
- Une couche avant formant un deuxième élément de protection en face avant ; cette couche avant peut être en verre de manière à pouvoir être traversée par les rayons lumineux captés ;

En vue du recyclage d'un module photovoltaïque, différentes méthodes ont déjà été envisagées. Une première méthode consiste à broyer le module dans sa totalité, puis de lui faire subir divers traitements thermiques et/ou chimiques afin de séparer les matériaux qui entrent dans sa composition, comme le verre, l'argent, le cuivre, le silicium... Cette première méthode est cependant coûteuse en énergie et peu respectueuse de l'environnement.

La demande de brevet WO2019/043329A1 propose une autre méthode de désassemblage d'un module photovoltaïque, qui consiste à retirer chaque couche du module pour la séparer, en la découpant avec un fil abrasif. Chaque couche retirée peut ensuite être traitée de manière séparée en vue de récupérer les matériaux d'intérêt. Cette dernière méthode présente certains inconvénients. Elle nécessite plusieurs postes de traitement distincts, d'abord pour la découpe, puis pour le broyage de chaque couche retirée.

La demande de brevet FR3017551A1 propose une méthode pour retirer la couche arrière et le premier film d'encapsulation jointifs, afin de mettre à nu les cellules photovoltaïques, celles-ci restant retenues sur l'autre film d'encapsulation. Ce retrait est réalisé en chauffant le module photovoltaïque par le dessous, en décollant une encoignure de l'ensemble formé par la couche arrière et le film d'encapsulation et en enroulant ledit ensemble pour le détacher. Le chauffage est réalisé à l'aide d'une lampe à infrarouge. Pour décoller l'ensemble, une assistance thermique est appliquée, par soufflage d'air chaud à une température comprise entre 300°C et 400°C.

Cette solution ne permet pas de décoller uniquement la couche arrière du module photovoltaïque. De plus, le chauffage de la couche intermédiaire à des températures élevées (plus de 300°C) est susceptible d'entraîner des dégagements de composés fluorés.

La demande de brevet n°FR3070541A1 décrit pour sa part le décollement de la couche arrière du panneau PV par écartement progressif.

Le but de l'invention est de proposer une solution permettant de décoller uniquement la couche arrière d'un module photovoltaïque, la solution permettant un décollement simple et propre de cette couche, sans la déchirer, en limitant les dégagements de composés fluorés et en permettant ensuite une valorisation de ladite couche et un désassemblage des autres couches du module.

L'invention permet notamment un décollement propre de la couche arrière, c'est-à-dire qu'aucun résidu de la couche arrière ne reste sur la couche intermédiaire d'encapsulation, après retrait, permettant un recyclage amélioré des différentes couches et matériaux du module photovoltaïque.

### Exposé de l'invention

Ce but est atteint par un procédé de désassemblage d'un module photovoltaïque, ledit module photovoltaïque comportant :
- Une couche arrière formant un premier élément de protection en face arrière du module photovoltaïque, cette couche arrière étant réalisée à base d'au moins un matériau polymère,
- Une couche intermédiaire, intercalée entre la couche arrière et une couche avant, et comprenant une enveloppe d'encapsulation dans laquelle sont placées des cellules photovoltaïques,
- La couche avant formant un deuxième élément de protection en face avant du module photovoltaïque,
- Le procédé comportant :
- Une étape préalable de décollement d'un coin ou d'un bord de la couche arrière,
- Une étape d'enroulement de la couche arrière autour d'un outil pour la détacher de la couche intermédiaire,
- L'outil étant chauffé de manière localisée lors de la mise en œuvre de l'étape d'enroulement,
- Une étape de réglage de la température de l'outil, ladite température étant choisie pour faire fondre au moins partiellement ladite couche intermédiaire.

Selon une autre particularité, l'étape préalable de décollement d'un coin ou d'un bord de la couche arrière est réalisée par préchauffage.

Selon une autre particularité, le préchauffage est mis en œuvre par chauffage localisé du module photovoltaïque.

Selon une autre particularité, le procédé comporte une étape ultérieure de retrait de la couche intermédiaire par ponçage à l'aide d'une bande abrasive.

L'invention concerne également un système de désassemblage d'un module photovoltaïque, employé pour mettre en œuvre le procédé tel que défini ci-dessus, ledit module photovoltaïque comportant :
- Une couche arrière formant un premier élément de protection en face arrière du module photovoltaïque, cette couche arrière étant réalisée à base d'au moins un matériau polymère,
- Une couche intermédiaire, intercalée entre la couche arrière et une couche avant et comprenant une enveloppe d'encapsulation dans laquelle sont placées des cellules photovoltaïques,
- La couche avant formant un deuxième élément de protection en face avant du module photovoltaïque,
- Le système comportant :

- Des moyens d'amorçage du retrait de la couche arrière,
- Un outil apte à décoller la couche arrière de la couche intermédiaire, ladite couche arrière étant destinée à venir s'enrouler autour de l'outil lors de son décollement,
- Des moyens de chauffage intégrés à l'outil.

Selon une particularité, ledit outil présente une forme allongée suivant un axe longitudinal et comporte une fente s'étendant suivant son axe longitudinal, formant un logement d'accueil pour un coin ou un bord de ladite couche arrière.

Selon une autre particularité, les moyens de chauffage intégrés à l'outil sont de type à induction.

Selon la présente invention, le système comporte des moyens de réglage de la température de l'outil, ladite température étant choisie pour faire fondre au moins partiellement ladite couche intermédiaire du module photovoltaïque.

Selon une autre particularité, le système comporte un support sur lequel vient prendre appui le module photovoltaïque, par sa face avant.

Selon une autre particularité, le système comporte un dispositif de préchauffage arrangé pour venir chauffer au moins une zone du support ou agencé pour venir chauffer directement la couche arrière du module photovoltaïque.

Selon une autre particularité, le dispositif de préchauffage comporte une ou plusieurs lampes à infrarouge ou des moyens de chauffage par induction.

### Brève description des figures

D'autres caractéristiques et avantages vont apparaître dans la description détaillée qui suit faite en regard des dessins annexés dans lesquels :
- La figure 1 représente, vue en perspective, une architecture multicouche d'un module photovoltaïque ;
- La figure 2 représente, vue en coupe, l'architecture multicouches d'un module photovoltaïque ;

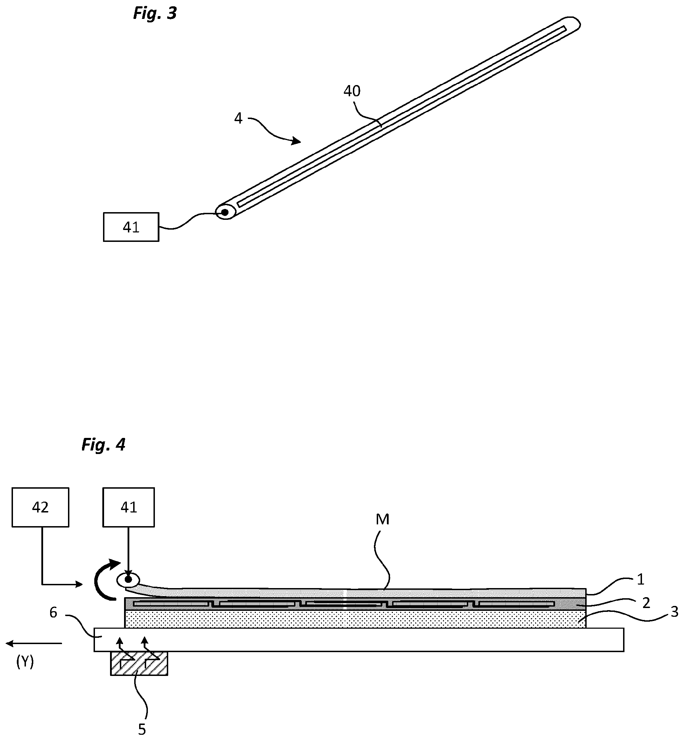

- La figure 3 montre un exemple de réalisation de l'outil employé dans le système de désassemblage de l'invention ;
- La figure 4 illustre de manière schématique le principe de désassemblage de la couche arrière du module photovoltaïque, mis en œuvre à l'aide du système de désassemblage de l'invention ;
- La figure 5 montre les différentes étapes du procédé de l'invention ;
- La figure 6 montre un exemple de réalisation d'une étape de désassemblage de la couche intermédiaire du module photovoltaïque ;

### Description détaillée d'au moins un mode de réalisation

### Module photovoltaïque

### Figure 1

### Figure 2

### Figure 4

Dans la suite de la description, la face avant du module photovoltaïque M correspond à une face du module recevant les rayons lumineux et la face arrière correspond à la face opposée à la face avant.

Dans la suite de la description, chaque couche du module photovoltaïque présente deux faces opposées, une première face orientée vers l'arrière et une deuxième face orientée vers l'avant.

Le module photovoltaïque comporte deux faces principales opposées, une première face 10 orientée vers l'arrière et une deuxième face 30 orientée vers l'avant.

Ci-après, par "élément de protection", on entend un élément pouvant présenter une fonction de rigidification et/ou une fonction de protection de surface.

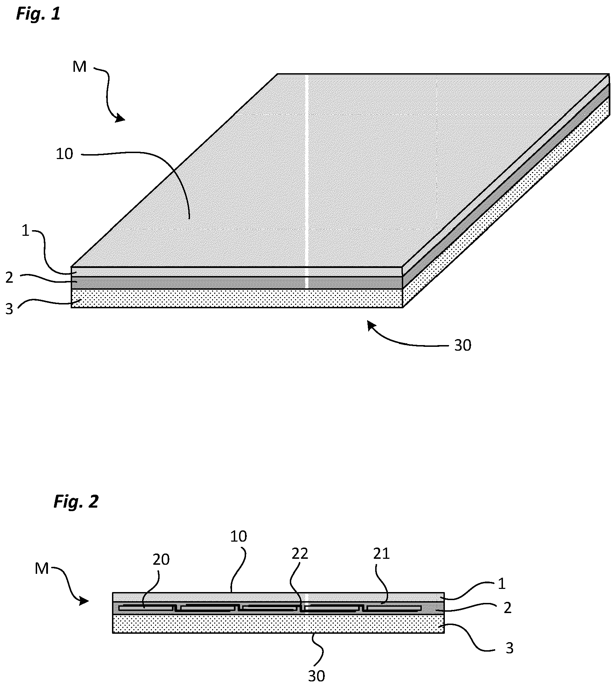

En référence à la figure 1 et à la figure 2, de manière connue, un module photovoltaïque comporte plusieurs couches superposées et assemblées entre elles :
- Une couche arrière 1 (appelée couramment "backsheet") formant un premier élément de protection en face arrière du module photovoltaïque ; cette couche arrière est habituellement réalisée dans un matériau de type polymère ;
- Une couche intermédiaire 2, intercalée entre la couche arrière et la couche avant (décrite ci-dessous), permettant l'assemblage d'un côté de la couche arrière et de l'autre côté de la couche avant ; cette couche intermédiaire comporte les cellules photovoltaïques 20, la connectique électrique 22 et une enveloppe d'encapsulation 21 arrangée autour des cellules photovoltaïques ;
- Une couche avant 3 formant un deuxième élément de protection en face avant du module photovoltaïque ; cette couche avant 3 est habituellement en verre et correspond à celle exposée aux rayons lumineux ;

Il faut noter que sur les figures annexées, le module photovoltaïque M est représenté retourné, de sorte que sa face arrière 10 est située au-dessus et sa face avant 30 est située au-dessous.

Pour des soucis de lisibilité sur les figures annexées, les différentes couches du module ne sont pas représentées à l'échelle. A titre d'exemple, la couche arrière 1 peut présenter une épaisseur de quelques centaines de µm (par exemple environ 350µm), la couche intermédiaire 2 peut présenter une épaisseur pouvant aller jusqu'à 1mm et la couche avant 3 peut présenter une épaisseur d'environ 3 à 4mm.

La couche arrière 1 peut notamment assurer une fonction d'imperméabilité aux gaz et à l'eau, une fonction de protection/isolation électrique et une fonction de protection mécanique. Cette couche arrière 1 peut être réalisée à base d'un polymère fluoré. Il peut s'agir du polyfluorure de vinyl (PVF), par exemple commercialisé sous le nom TEDLAR (marque déposée) par la société DuPont (marque déposée).

De manière non limitative, la couche arrière 1 peut elle-même être composée d'un empilement de plusieurs strates : une strate de PVF, une strate en PET (poly(téréphtalate) d'éthylène), une strate de PVF.

Dans la couche intermédiaire 2, l'enveloppe d'encapsulation 21 est classiquement réalisée dans un polymère tel que de l'EVA (Ethylène-Acétate de Vinyl) formant un matériau sur lequel peuvent adhérer la couche arrière 1 d'un côté et la couche avant 3 de l'autre côté et permettre l'assemblage des trois couches entre elles. Les trois couches peuvent être assemblées entre elles par laminage à chaud, de sorte que la couche arrière et la couche avant viennent adhérer au matériau de l'enveloppe d'encapsulation, formant ainsi un empilement monobloc. Il faut noter que le matériau formant cette couche intermédiaire d'encapsulation peut également être une polyoléfine thermoplastique (TPO), une polyoléfine élastomère (POE) ou un ionomère.

Dans la couche intermédiaire 2, les cellules photovoltaïques 20 sont généralement connectées entre elles, en série/parallèle, formant plusieurs chaînes ("string" en anglais) de cellules. Des éléments de connexion électrique 22, par exemple en cuivre, permettent d'assurer les liaisons électriques entre les cellules 20 dans chaque chaîne.

Le module photovoltaïque M peut comporter un cadre (non représenté), par exemple en aluminium, agencé en périphérie de l'empilement pour rigidifier le module M. Pour la mise en œuvre de l'invention décrite ci-dessous, ce cadre, ainsi que la boîte de jonction électrique (non représentée) généralement fixée sur la face arrière du module M, sont préalablement retirés. Le procédé de l'invention est en effet dédié plus particulièrement au traitement de l'empilement de couches du module photovoltaïque M.

L'invention vise plus particulièrement le désassemblage de la couche arrière 1 du module photovoltaïque M et son décollement du reste du module photovoltaïque.

Pour ce désassemblage, le module photovoltaïque vient avantageusement prendre appui par sa face avant 30 contre un support 6. De manière non limitative, le module photovoltaïque peut être maintenu contre ce support 6 par des moyens mécaniques (bridage par exemple) ou par des moyens de type aspiration.

Le support 6 est avantageusement réalisé dans un matériau métallique.

### Outil de décollement

### Figure 3

### Figure 4

Pour décoller la couche arrière 1 du module photovoltaïque M, le système de l'invention comporte un outil 4 spécifique sur lequel on vient enrouler cette couche arrière 1.

Cet outil 4 présente une forme allongée suivant un axe dit longitudinal (X). Il peut prendre la forme d'une tige, d'un rouleau, d'une lame... Sa section transversale peut être circulaire, carrée ou de forme quelconque. L'outil présente une longueur au moins égale à la longueur ou la largeur de la couche arrière 1 du module photovoltaïque pour que celle-ci puisse être enroulée sur l'outil 4.

Suivant son axe longitudinal, l'outil 4 comporte avantageusement une fente 40 destinée à recevoir un coin ou un bord de la couche arrière à retirer. La fente 40 s'étend sur une longueur suffisante pour recevoir ce coin ou ce bord.

Selon l'invention, l'outil 4 intègre des moyens de chauffage 41. Autrement dit, ces moyens de chauffage 41 permettent de chauffer la surface externe de l'outil à une température donnée, ce qui permet de faciliter le décollage lors de l'enroulement.

La température est choisie suffisante pour permettre de ramollir au moins partiellement la couche intermédiaire 2 d'encapsulation sur laquelle vient adhérer la couche arrière 1, en la faisant fondre, permettant ainsi un décollement plus facile de la couche arrière 1. Classiquement, cette température est comprise entre 90°C et 150°C, par exemple située autour de 100°C.

Les moyens de chauffage sont par exemple de type à induction, de type résistif ou équivalent. La température est par exemple réglable à plus ou moins 5°C.

L'outil 4 permet dans un premier temps de soulever la couche arrière (avantageusement par préchauffage - voir ci-après) puis de la maintenir fermement pour ensuite l'enrouler sur sa surface externe. Le maintien de la couche arrière 1 sur l'outil 4 peut être mécanique ou réalisé à l'aide d'une préhension par le vide. Pour amorcer le retrait de la couche arrière, un préchauffage peut être mis en œuvre mais d'autres moyens pourraient être envisagés (moyens mécaniques par exemple).

Pour alimenter les moyens de chauffage 41, le système comporte une source alimentation électrique, externe ou interne à l'outil 4.

### Dispositif de préchauffage

### Figure 4

Selon un aspect particulier de l'invention, pour amorcer le décollement de la couche arrière 1, le système comporte avantageusement un dispositif de préchauffage 5. Ce dispositif de préchauffage 5 permet de réaliser un chauffage localisé du coin ou du bord de la couche arrière 1 du module photovoltaïque M, afin de la désolidariser et de la saisir pour insérer ce coin ou ce bord dans la fente 40 de l'outil 4. Grâce à ce dispositif, on vient avantageusement ramollir la couche intermédiaire 2 d'encapsulation sur une zone déterminée, avantageusement en aval ou au niveau de la position de l'outil 4 lors de l'enroulement de la couche arrière 1 sur l'outil 4.

Ce dispositif de préchauffage 5 est par exemple agencé pour chauffer une zone du support 6 sur lequel le module photovoltaïque vient prendre appui par sa face avant 30 ou pour chauffer directement du côté de la face arrière 10 du module photovoltaïque M. Le dispositif de préchauffage 5 permet in fine de chauffer une surface plus ou moins étendue du module photovoltaïque M.

Le dispositif de préchauffage 5 peut par exemple venir chauffer l'ensemble du support 6 de manière à couvrir toute la surface du module photovoltaïque.

Il peut également venir chauffer une zone plus réduite du support 6, le module photovoltaïque M et/ou le dispositif de préchauffage étant par exemple déplacé au fur et à mesure du décollement de la couche arrière 1 pour faire coïncider la zone en cours de décollement avec la zone du support 6 qui est chauffée par le dispositif de préchauffage 5. Ce principe s'applique également lorsque le chauffage est réalisé du côté de la face arrière 10 du module photovoltaïque M.

De manière non limitative, le dispositif de préchauffage peut être réalisé sous la forme de lampes infrarouges ou de moyens de chauffage fonctionnant par induction (notamment lorsque le support 6 est métallique).

### Rotation de l'outil et déplacement relatif outil/module photovoltaïque

### Figure 4

Afin de venir enrouler la couche arrière sur l'outil 4, l'outil est monté sur l'axe d'un moteur 42 afin d'être entraîné en rotation sur lui-même.

En outre, l'enroulement de la couche arrière 1 sur l'outil 4 est permis par un déplacement en translation de l'outil 4 et/ou du module photovoltaïque M suivant une direction d'avancée (Y) qui est perpendiculaire à l'axe longitudinal de l'outil 4 et parallèle au plan du module photovoltaïque M.

De manière avantageuse, il faut noter que le retrait de la couche arrière, par pelage, est amélioré lorsque l'angle de pelage (correspondant à l'angle formé par la direction de traction lors du retrait) est compris entre 90° et 180°, et avantageusement égal à 180°. Avec un angle de pelage de 180°, on a remarqué que la couche arrière 1 était maintenue intacte après retrait, facilitant ainsi son recyclage après retrait.

### Procédé de désassemblage

### Figure 5

### Figure 6

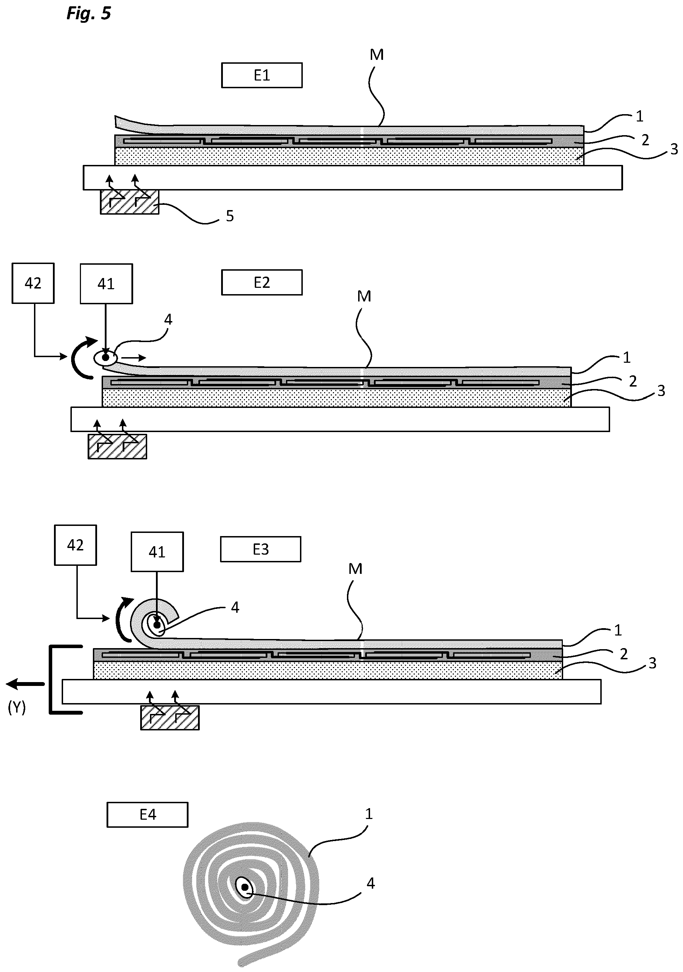

En liaison avec la figure 5, le procédé de décollement de la couche arrière 1 du module photovoltaïque M comporte les étapes décrites ci-dessous.

E1 : Chauffage au moins localisé d'un coin ou d'un bord du module photovoltaïque M pour amorcer le décollement. Ce coin ou ce bord correspond donc à celui par lequel la couche arrière 1 va commencer à être retirée du reste du module photovoltaïque M.

Le chauffage localisé est réalisé à l'aide du dispositif de préchauffage 5, réglé pour faire en sorte que le module photovoltaïque M soit à une température suffisante (par exemple 100°C environ pour l'EVA) pour permettre de ramollir le matériau formant la couche intermédiaire 2 d'encapsulation.

E2 : Une fois le bord ou le coin décollé, celui-ci est inséré et maintenu dans la fente 40 de l'outil 4 de décollement.

E3 : L'outil 4 est chauffé par ses moyens de chauffage intégrés. Il est actionné en rotation de manière à tourner autour de son axe. L'outil 4 et/ou le module photovoltaïque M est déplacé en translation suivant la direction d'avancée (Y) de manière à venir enrouler progressivement la couche arrière 1 autour de l'outil 4. Le dispositif de préchauffage 5 peut être maintenu actif pour chauffer une zone particulière du module photovoltaïque, par exemple celle située juste en aval de l'outil 4 lors du processus de décollage, ou l'ensemble du module photovoltaïque.

E4 : L'ensemble de la couche arrière 4 est décollé du module photovoltaïque M et enroulé autour de l'outil 4. Après retrait, cette couche 1 ne comporte aucun résidu de la couche intermédiaire 2 d'encapsulation, ce qui permet son recyclage et sa valorisation.

Il faut noter que la séparation peut s'avérer plus compliquée lorsque le matériau de la couche d'encapsulation est un polymère réticulé tel que par exemple l'EVA. Lorsque ce matériau est un polymère non réticulé, comme par exemple les polyoléfines, la séparation est plus aisée.

Une fois la couche arrière 1 retirée, il est possible de venir retirer les couches restantes du module photovoltaïque.

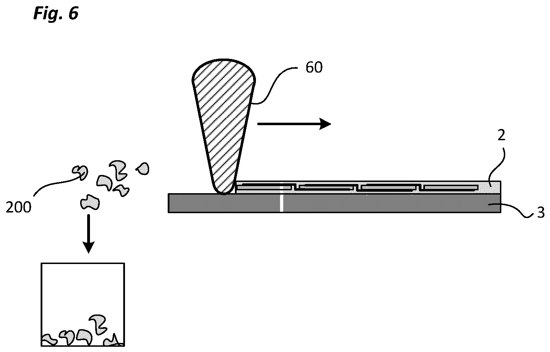

En liaison avec la figure 6, la couche intermédiaire 2 d'encapsulation peut ainsi être retirée par usinage, par exemple par ponçage à l'aide d'une bande abrasive 60 ou par exemple par fraisage localisé. Les techniques de désassemblage connues pour retirer ces couches restantes peuvent ainsi être mises en œuvre. Il est alors possible de récupérer les éléments actifs du module initial sous forme de copeaux 200 qui pourraient ensuite être traités afin de récupérer les métaux d'intérêt.

Le verre solaire de la couche avant 3 pourra être réinjecté dans la fabrication de modules photovoltaïques ou d'autres applications
Les composés fluorés contenus dans la couche arrière 1 pourront être traités dans une filière spécialisée.

Les métaux contenus dans les cellules (silicium, argent, aluminium, indium...) pourront être récupérés et recyclés.

L'EVA de la couche intermédiaire 2 pourra être réutilisé dans la fabrication de tapis de sol, semelles de chaussures etc....

Une étape ultérieure de nettoyage de l'outil 4 peut également être prévue. Il s'agit par exemple de venir brûler le matériau de la couche intermédiaire 2 d'encapsulation qui aurait pu se déposer sur l'outil 4 lors du décollement.

L'invention présente ainsi de nombreux avantages :
- Solution simple de décollement de la couche arrière 1, sans risque de déchirure de cette couche arrière 1 ;
- Retrait simple et propre, sans résidu de dépôt de la couche intermédiaire 2 ;
- Aucune dégradation de la couche intermédiaire 2, qui peut ainsi être retirée par une autre technique (usinage/ponçage ou autre) ;
- Récupération de la couche arrière 1 sous la forme d'un rouleau, facilement exploitable pour recyclage et valorisation ;

## Revendications

1. Procédé de désassemblage d'un module photovoltaïque, ledit module photovoltaïque comportant :
- Une couche arrière (1) formant un premier élément de protection en face arrière du module photovoltaïque (M), cette couche arrière étant réalisée à base d'au moins un matériau polymère,
- Une couche intermédiaire, intercalée entre la couche arrière (1) et une couche avant (3), et comprenant une enveloppe d'encapsulation (21) dans laquelle sont placées des cellules photovoltaïques (20),
- La couche avant (3) formant un deuxième élément de protection en face avant du module photovoltaïque (M),
- Le procédé comportant une étape d'enroulement de la couche arrière autour d'un outil (4) pour la détacher de la couche intermédiaire,
- Le procédé comportant également une étape préalable de décollement d'un coin ou d'un bord de la couche arrière,
**Caractérisé en ce que**:
- L'outil (4) est chauffé de manière localisée par des moyens de chauffage intégrés à l'outil (4) lors de la mise en œuvre de l'étape d'enroulement,
- Le procédé comporte une étape de réglage de la température de l'outil (4), ladite température étant choisie pour faire fondre au moins partiellement ladite couche intermédiaire.

2. Procédé selon la revendication 1, **caractérisé en ce que** l'étape préalable de décollement du coin ou du bord de la couche arrière est mise en œuvre par préchauffage.

3. Procédé selon la revendication 2, **caractérisé en ce que** le préchauffage est mis en œuvre par chauffage localisé du module photovoltaïque.

4. Procédé selon l'une des revendications 1 à 3, **caractérisé en ce qu'**il comporte une étape ultérieure de retrait de la couche intermédiaire (2) par ponçage à l'aide d'une bande abrasive.

5. Système de désassemblage d'un module photovoltaïque, employé pour mettre en œuvre le procédé tel que défini dans l'une des revendications 1 à 4, ledit module photovoltaïque comportant :
- Une couche arrière (1) formant un premier élément de protection en face arrière du module photovoltaïque (M), cette couche arrière (1) étant réalisée à base d'au moins un matériau polymère,
- Une couche intermédiaire, intercalée entre la couche arrière (1) et une couche avant (3) et comprenant une enveloppe d'encapsulation (21) dans laquelle sont placées des cellules photovoltaïques (20),
- La couche avant (3) formant un deuxième élément de protection en face avant du module photovoltaïque (M),
- Ledit système de désassemblage du module photovoltaïque comportant:
- Des moyens d'amorçage du retrait de la couche arrière,
- Un outil (4) apte à décoller la couche arrière (1) de la couche intermédiaire, ladite couche arrière (1) étant destinée à venir s'enrouler autour de l'outil lors de son décollement,
**Caractérisé en ce que** ledit système de désassemblage du module photovoltaïque comporte également:
- Des moyens de chauffage intégrés à l'outil (4),
- Des moyens de réglage de la température de l'outil, ladite température étant choisie pour faire fondre au moins partiellement ladite couche intermédiaire du module photovoltaïque.

6. Système selon la revendication 5, **caractérisé en ce que** ledit outil (4) présente une forme allongée suivant un axe longitudinal et comporte une fente (40) s'étendant suivant son axe longitudinal, formant un logement d'accueil pour un coin ou un bord de ladite couche arrière (1).

7. Système selon la revendication 5 ou 6, **caractérisé en ce que** les moyens de chauffage (41) intégrés à l'outil sont de type à induction.

8. Système selon l'une des revendications 5 à 7, **caractérisé en ce qu'**il comporte un support (6) sur lequel vient prendre appui le module photovoltaïque, par sa face avant.

9. Système selon la revendication 8, **caractérisé en ce qu'**il comporte un dispositif de préchauffage (5) arrangé pour venir chauffer au moins une zone du support (6) ou agencé pour venir chauffer directement la couche arrière (1) du module photovoltaïque.

10. Système selon la revendication 9, **caractérisé en ce que** le dispositif de préchauffage comporte une ou plusieurs lampes à infrarouge ou des moyens de chauffage par induction.

## Patentansprüche

1. Verfahren zum Demontieren eines Photovoltaikmoduls, wobei das Photovoltaikmodul umfasst:
- Eine hintere Schicht (1), die ein erstes Schutzelement auf der Rückseite des Photovoltaikmoduls (M) bildet, wobei diese hintere Schicht auf Basis mindestens eines Polymermaterials ausgeführt ist,
- Eine Zwischenschicht, die zwischen der hinteren Schicht (1) und einer vorderen Schicht (3) angeordnet ist und ein Kapselungsgehäuse (21) aufweist, in dem Photovoltaikzellen (20) platziert sind,
- Wobei die vordere Schicht (3) ein zweites Schutzelement auf der Vorderseite des Photovoltaikmoduls (M) bildet,
- Wobei das Verfahren, das einen Schritt des Wickelns der hinteren Schicht um ein Werkzeug (4) umfasst, um sie von der Zwischenschicht zu lösen,
- Wobei das Verfahren auch einen vorherigen Schritt das Ablösens einer Ecke oder eines Rands der hinteren Schicht umfasst,
**Dadurch gekennzeichnet, dass**:
- Das Werkzeug (4) beim Durchführen des Wickelschritts durch in das Werkzeug (4) integrierte Heizmittel lokalisiert erwärmt wird;
- Das Verfahren einen Schritt des Einstellens der Temperatur des Werkzeugs (4) umfasst, wobei die Temperatur so gewählt wird, dass die Zwischenschicht mindestens teilweise schmilzt.

2. Verfahren nach Anspruch 1, **dadurch gekennzeichnet, dass** der vorherige Schritt des Ablösens der Ecke oder des Randes der hinteren Schicht durch Vorwärmen durchgeführt wird.

3. Verfahren nach Anspruch 2, **dadurch gekennzeichnet, dass** das Vorwärmen durch lokalisiertes Erwärmen des Photovoltaikmoduls durchgeführt wird.

4. Verfahren nach einem der Ansprüche 1 bis 3, **dadurch gekennzeichnet, dass** es einen nachfolgenden Schritt des Entfernens der Zwischenschicht (2) durch Schleifen mithilfe eines Schleifbands umfasst.

5. System zum Demontieren eines Photovoltaikmoduls, das zur Durchführung des Verfahrens nach einem der Ansprüche 1 bis 4 verwendet wird, wobei das Photovoltaikmodul umfasst:
- Eine hintere Schicht (1), die ein erstes Schutzelement auf der Rückseite des Photovoltaikmoduls (M) bildet, wobei diese hintere Schicht (1) auf Basis mindestens eines Polymermaterials ausgeführt ist,
- Eine Zwischenschicht, die zwischen der hinteren Schicht (1) und einer vorderen Schicht (3) angeordnet ist und ein Kapselungsgehäuse (21) aufweist, in dem Photovoltaikzellen (20) platziert sind,
- Wobei die vordere Schicht (3) ein zweites Schutzelement auf der Vorderseite des Photovoltaikmoduls (M) bildet,
- Wobei das System zum Demontieren des Photovoltaikmoduls umfasst:
- Mittel zur Einleitung des Entfernens der hinteren Schicht;
- Ein Werkzeug (4), das in der Lage ist, die hintere Schicht (1) von der Zwischenschicht abzulösen, wobei die hintere Schicht (1) dazu bestimmt ist, bei ihrem Ablösen um das Werkzeug gewickelt zu werden,
**Dadurch gekennzeichnet, dass** das System zum Demontieren des Photovoltaikmoduls auch umfasst:
- In das Werkzeug integrierte Heizmittel (4);
- Mittel zum Einstellen der Temperatur des Werkzeugs, wobei die Temperatur so gewählt wird, dass die Zwischenschicht des Photovoltaikmoduls mindestens teilweise schmilzt.

6. System nach Anspruch 5, **dadurch gekennzeichnet, dass** das Werkzeug (4) eine entlang einer Längsachse langgestreckte Form aufweist und einen Schlitz (40) umfasst, der sich entlang seiner Längsachse erstreckt und eine Aufnahme für eine Ecke oder einen Rand der hinteren Schicht (1) bildet.

7. System nach Anspruch 5 oder 6, **dadurch gekennzeichnet, dass** die in das Werkzeug integrierten Heizmittel (41) vom Typ mit Induktion sind.

8. System nach einem der Ansprüche 5 bis 7, **dadurch gekennzeichnet, dass** es einen Träger (6) umfasst, auf dem das Photovoltaikmodul mit seiner Vorderseite aufliegt.

9. System nach Anspruch 8, **dadurch gekennzeichnet, dass** es eine Vorwärmvorrichtung (5) umfasst, die dazu ausgebildet ist, mindestens eine Zone des Trägers (6) zu erwärmen, oder dazu ausgebildet ist, die hintere Schicht (1) des Photovoltaikmoduls direkt zu erwärmen.

10. System nach Anspruch 9, **dadurch gekennzeichnet, dass** die Vorwärmvorrichtung eine oder mehrere Infrarotlampen oder Induktionsheizmittel umfasst.

## Claims

1. Method for disassembling a photovoltaic module, said photovoltaic module comprising:
- a back layer (1) forming a first protective element on the back face of the photovoltaic module (M), this back layer being made based on at least one polymer material,
- an intermediate layer interposed between the back layer (1) and a front layer (3) and comprising an encapsulating envelope (21) in which photovoltaic cells (20) are placed,
- the front layer (3) forming a second protective element on the front face of the photovoltaic module (M),
- the method comprising a step of winding the back layer around a tool (4) in order to detach it from the intermediate layer,
- the method also comprising a prior step of detaching a corner or edge of the back layer,
**characterized in that**:
- the tool (4) is heated in a localized manner by heating means integrated in the tool (4) during the implementation of the winding step,
- the method comprises a step of adjusting the temperature of the tool (4), said temperature being chosen so as to at least partially melt said intermediate layer.

2. Method according to Claim 1, **characterized in that** the prior step of detaching the corner or edge of the back layer is implemented by preheating.

3. Method according to Claim 2, **characterized in that** the preheating is implemented by localized heating of the photovoltaic module.

4. Method according to any of Claims 1 to 3, **characterized in that** it comprises a subsequent step of removing the intermediate layer (2) by sanding with the aid of an abrasive belt.

5. System for disassembling a photovoltaic module, employed to implement the method as defined in any of Claims 1 to 4, said photovoltaic module comprising:
- a back layer (1) forming a first protective element on the back face of the photovoltaic module (M), this back layer (1) being made based on at least one polymer material,
- an intermediate layer interposed between the back layer (1) and a front layer (3) and comprising an encapsulating envelope (21) in which photovoltaic cells (20) are placed,
- the front layer (3) forming a second protective element on the front face of the photovoltaic module (M),
- said system for disassembling the photovoltaic module comprising:
- means for initiating the removal of the back layer,
- a tool (4) capable of detaching the back layer (1) from the intermediate layer, said back layer (1) being intended to be wound around the tool during its detachment,
**characterized in that** said system for disassembling the photovoltaic module also comprises:
- heating means integrated in the tool (4),
- means for adjusting the temperature of the tool, said temperature being chosen so as to at least partially melt said intermediate layer of the photovoltaic module.

6. System according to Claim 5, **characterized in that** said tool (4) has an elongate shape along a longitudinal axis and has a slot (40) extending along its longitudinal axis, forming an accommodating housing for a corner or edge of said back layer (1).

7. System according to Claim 5 or 6, **characterized in that** the heating means (41) integrated in the tool are of the induction type.

8. System according to any of Claims 5 to 7, **characterized in that** it comprises a support (6) on which the photovoltaic module comes to bear by way of its front face.

9. System according to Claim 8, **characterized in that** it comprises a preheating device (5) arranged to heat at least a zone of the support (6) or arranged to directly heat the back layer (1) of the photovoltaic module.

10. System according to Claim 9, **characterized in that** the preheating device comprises one or more infrared lamps or induction heating means.
